# EUROPÄISCHE PATENTANMELDUNG

(11) **EP 1 160 874 A2**
(43) Veröffentlichungstag der Anmeldung: **05.12.2001**
(21) Anmeldenummer: 01112439.3
(22) Anmeldetag: 22.05.2001
(51) Int. Cl.: H01L 29/78, H01L 29/10

(54) **Feldeffektgesteuertes, vertikales Halbleiterbauelement**

(30) Priorität: 30.05.2000 DE 10026925
(71) Anmelder: Infineon Technologies AG, 81669 München (DE)
(72) Erfinder: Wener, Wolfgang, Dr., 81545 München (DE)
(74) Vertreter: Bickel, Michael

(57) **Zusammenfassung**

Die Erfindung betrifft ein feldeffektgesteuertes, vertikales Halbleiterbauelement, das in einem Halbleiterkörper angeordnet ist, mit
- mindestens einer Innenzone des ersten Leitungstyps,
- mindestens einer an die Innenzone und an eine erste Oberfläche des Halbleiterkörpers angrenzende Basiszone des zweiten Leitungstyps,
- mindestens einer in jeder Basiszone angeordneten Sourcezone des ersten Leitungstyps,
- mindestens eine weitere Basiszone des zweiten Leitungstyps, die von der Basiszone durch eine Zwischenzone des ersten Leitungstyps beabstandet ist, und
- mindestens eine Sourcekontaktzone, die die Sourcezonen, die Basiszonen und die weiteren Basiszonen niederohmig miteinander verbindet.

## Beschreibung

Die Erfindung betrifft ein feldeffektgesteuertes, vertikales Halbleiterbauelement der im Oberbegriff des Patentanspruchs 1 genannten Art. Demgemäss ist ein feldeffektgesteuertes, vertikales Halbleiterbauelement vorgesehen, das in einem Halbleiterkörper angeordnet ist, mit mindestens einer Innenzone des ersten Leitungstyps, mindestens einer an die Innenzone und an eine erste Oberfläche des Halbleiterkörpers angrenzende Basiszone des zweiten Leitungstyps und mindestens einer in jeder Basiszone angeordneten Sourcezone des ersten Leitungstyps.

Derartige feldeffektgesteuerte, vertikale Halbleiterbauelemente, die als V-MOSFET, D-MOSFET, U-MOSFET ausgebildet sein können, sind vielfach bekannt und beispielsweise in B. Jayant Baliga, Power Semiconductor Devices, PWS Publishing Company, Seiten 336 bis 339, ausführlich beschrieben.

Im Sperrbetrieb solcher vertikaler Halbleiterbauelemente können Spannungen auftreten, die größer sind als die Durchbruchspannung des Halbleiterbauelementes. Der dadurch verursachte Drain/Source-Sperrstrom verursacht aufgrund des ohmschen Widerstandes in der Basiszone dort einen diesem Widerstand entsprechenden Spannungsabfall. Übersteigt dieser Spannungsabfall die Einschaltspannung einer parasitären Diode am pn-Übergang zwischen Basiszone und Drainzone, dann wird ein parasitärer Bipolartransistor, dessen Emitter, Basis und Kollektor durch die Sourcezone, Basiszone und Drainzone gebildet werden, unerwünschterweise eingeschaltet. Dieses unerwünschte Einschalten des parasitären Bipolartransistors wird auch als Latch-up-Effekt bezeichnet. In einem solchen Fall sinkt die Sperrspannung des Halbleiterbauelementes signifikant, d. h. um ca. 30% bis 50%, ab, was typischerweise zur unmittelbaren Zerstörung des Halbleiterbauelementes selbst führt. Verstärkt wird dieser Latch-up-Effekt durch die Tatsache, dass der Spannungsdurchbruch begünstigt durch die Krümmung des pn-Übergangs in der Regel am Rande der Basiszone auftritt.

Zur Verbesserung der Latch-up-Festigkeit sollte der Schichtwiderstand in der Basiszone des Halbleiterbauelementes also möglichst klein sein, so dass hier ein möglichst geringer Spannungsabfall entsteht. Allerdings hängt die Schwellenspannung des Halbleiterbauelementes in sehr starken Maße von der Dotierungskonzentration in der Basiszone ab, wodurch der Reduzierung des Schichtwiderstandes in der Basiszone enge Grenzen gesetzt sind.

Wird die Dotierungskonzentration in der Basiszone zum Zwecke der Reduzierung des Schichtwiderstandes und somit zur Verbesserung der Latch-up-Festigkeit dennoch vergrößert, birgt dies zudem die Gefahr der Kristallfehlerbildung, die bei Verwendung einer sehr hohen Dosis nur begrenzt wieder ausheilbar sind. Außerdem besteht bei Verwendung einer sehr hohen Implantationsdosis immer auch die Gefahr einer unerwünschten Ausdiffusion von Dotierstoffen in den Halbleiterkörper. Grundsätzlich wird jedoch ein Halbleiterbauelement, bei dem die Basiszonen unter Berücksichtigung all dieser Maßnahmen eine sehr hohe Dotierungskonzentration aufweisen, bei entsprechend hohen Sperrstromdichten in den Basiszonen dennoch "latchen".

Alternativ kann es auch dazu kommen, dass bei sehr schneller Änderung der Drainspannung ein kapazitiver Strom fließt, der zu einem entsprechenden Spannungsabfall in der Basiszone führt, so dass der parasitäre Bipolartransistor eingeschaltet wird.

Es muss also sichergestellt werden, dass im Sperrbetrieb auch bei einem Übersteigen der Sperrspannung über die Durchbruchspannung oder einer schnellen Änderung der Drainspannung der parasitäre Bipolartransistor des Halbleiterbauelements nicht aktiv wird, d. h. nicht latched.

Der vorliegenden Erfindung liegt daher die Aufgabe zugrunde, ein Halbleiterbauelement der eingangs genannten Art bereitzustellen, bei dem im Sperrbetrieb ein unerwünschtes Einschalten eines parasitären Transistors weitestgehend ausgeschlossen ist.

Erfindungsgemäß wird diese Aufgabe durch ein Halbleiterbauelement mit den Merkmalen des Patentanspruchs 1 gelöst.

Demnach ist ein Halbleiterbauelement der eingangs genannten Art vorgesehen, das gekennzeichnet ist durch mindestens eine weitere Basiszone des zweiten Leitungstyps, die von der Basiszone durch eine Zwischenzone des ersten Leitungstyps beabstandet ist, und mindestens eine Sourcekontaktzone, die die Sourcezonen, die Basiszonen und die weiteren Basiszonen niederohmig miteinander verbindet.

Das Grundprinzip der vorliegenden Erfindung besteht in der Bereitstellung unterschiedlicher, voneinander räumlich getrennter Basiszonen. Dabei ist die erste Basiszone die eigentliche, stromführende Basiszone, welche zur Ausbildung des Kanals im eingeschalteten Zustand vorgesehen ist. Die weitere Basiszone, die typischerweise unterhalb der eigentlichen Basiszone angeordnet ist, ist im Sperrbetrieb zur Aufnahme einer durch einen Sperrstrom verursachten Sperrspannung vorgesehen. Im Sperrbetrieb fällt ein durch den Sperrstrom verursachter Spannungsabfall ausschließlich in der weiteren Basiszone ab. Ein Spannungsabfall in der weiteren Basiszone führt aber nicht zur Ladungsträgerinjektion und somit nicht zum Einschalten des parasitären Bipolartransistors; es wird damit vorteilhafterweise ein Halbleiterbauelement ohne Latch-up-Effekt zur Verfügung gestellt.

Der besondere Vorteil der Erfindung liegt darüber hinaus darin, dass der Spannungsabfall in der weiteren Basiszone beliebig groß sein kann, ohne dass der parasitäre Bipolartransistor einschaltet. Somit kann die Dotierungskonzentration in der Basiszone optimal auf die Einstellung der Schwellenspannung des Halbleiterbauelementes eingestellt werden; die Berücksichtigung der Latch-up-Festigkeit über eine geeignete Wahl der Dotierungskonzentration spielt hier eine geringe Rolle. Es wird damit ein Halbleiterbauelement bereitgestellt, das der Herstellungstechnologie vorteilhafterweise größere Freiheitsgrade bietet.

Die weitere Basiszone ist, wie bereits erwähnt, üblicherweise unterhalb der eigentlichen Basiszone angeordnet und über eine hochleitende Sourcekontaktzone mit dieser Basiszone verbunden. Besonders vorteilhaft ist es, wenn die weitere Basiszone als in der Innenzone vergrabene Schicht ausgebildet ist. Diese hochdotierte, vergrabene Basiszone kann typischerweise durch Hochdosis-Ionenimplantation in die Innenzone eingebracht werden.

In einer besonders vorteilhaften Ausführungsform besteht die weitere Basiszone aus zwei unterschiedlichen Bereichen, die untereinander angeordnet sind und aneinander angeschlossen sind. Diese beiden Bereiche weisen jeweils unterschiedlichen Eindringtiefen und unterschiedliche Dotierungskonzentrationen auf.

Besonders vorteilhaft ist es, wenn der erste Bereich eine hohe Dotierungskonzentration aufweist und bezogen auf die erste Oberfläche oberhalb des zweiten Bereiches, der eine sehr viel niedrigere Dotierungskonzentration aufweist, angeordnet ist. Der erste hochdotierte Bereich nimmt somit nahezu den gesamten in der weiteren Basiszone auftretenden Sperrstrom und somit die dort abfallende Spannung auf. Der zweite, niedrig dotierte Bereich der weiteren Basiszone hat vorteilhafterweise eine Kompensationswirkung für die Dotierung im Draingebiet.

Der niedrig dotierte zweite Bereich der weiteren Basiszone nimmt zu Gunsten der Innenzone (=Draingebiet) einen signifikanten Anteil der Drain-Source-Spannung auf, wodurch die Innenzone höher dotiert werden kann. Aufgrund der höheren Dotierung der Innenzone kann vorteilhafterweise bei gleicher Durchbruchspannung der Einschaltwiderstand R_{ON} signifikant verringert werden, wodurch die Leistungsaufnahme des Ableiterbauelementes entsprechend geringer wird.

Typischerweise weisen die weiteren Basiszonen eine deutlich höhere Dotierungskonzentration auf wie die eigentlichen Basiszonen. Es wäre jedoch auch vorteilhaft, wenn die weiteren Basiszonen eine gleiche bzw. geringere Dotierungskonzentration als die eigentlichen Basiszonen aufweisen. In diesem Fall kann aufgrund des höheren Schichtwiderstandes die vertikale Ausdehnung der weiteren Basiszonen deutlich geringer sein, was zur Folge hat, dass die vertikale Ausdehnung dieses JFETs und damit der Widerstand dieses Teils des Halbleiterbauelementes geringer wird. Im Allgemeinen sollte die weitere Basiszone mindestens so hoch dotiert sein, dass sie im Betriebsfall nicht ausgeräumt wird.

Die Basiszonen und weitere Basiszonen sind untereinander durch eine hochleitfähige, niederimpedante Kontaktierung miteinander elektrische verbunden. Diese wird nachfolgend als Sourcekontaktzone bezeichnet und kann gemäß einem ersten Ausführungsbeispiel aus sehr hoch dotiertem Silizium desselben Leitungstyps wie die Basiszone und weiteren Basiszone bestehen. Die Sourcekontaktzonen sind typischerweise grabenförmig von der Scheibenvorderseite in den Halbleiterkörper eingebracht. Besonders vorteilhaft ist es, wenn die Dotierungskonzentration dieser Sourcekontaktzone deutlich höher ist als die entsprechenden Dotierungskonzentrationen in der Basiszone und weiteren Basiszone.

In einem zweiten Ausführungsbeispiel kann die Sourcekontaktzone auch durch einen hochleitfähigen Metallstöpsel, der beispielsweise Wolfram oder eine Wolfram enthaltende Legierung enthält, ausgebildet sein.

In einem dritten Ausführungsbeispiel kann die Sourcekontaktzone auch durch ein an einer Grabenwand aufgebrachtes Silizid, beispielsweise Platinsilizium (PtSi), das mit hochdotiertem Polysilizium aufgefüllt ist, ausgebildet sein.

Das erfindungsgemäße feldeffektgesteuerte Halbleiterbauelement kann als vertikale Transistorstruktur, beispielsweise als D-MOSFET, V-MOSFET, U-MOSFET, etc. ausgebildet sein. Derartige Transistorstrukturen weisen im Wesentlichen eine Dreischichtstruktur bestehend aus Drainzone, Basiszone und Sourcezone auf. Ist diese Transistorstruktur als Leistungshalbleiterbauelement ausgebildet, dann ist zwischen der Basiszone und der Drainzone eine Innenzone als Driftstrecke angeordnet, die niedriger als die Drainzone dotiert ist. Sourcezone, Drainzone und ggf. Innenzone weisen denselben Leitungstyp auf, die Basiszone, die zur Ausbildung einer Kanalzone unter Steuerung der Gateelektrode vorgesehen ist, einen entgegengesetzten Leitungstyp auf.

Alternativ kann das Halbleiterbauelement auch als vertikaler IGBT (Insulated Gate Bipolar Transistor) ausgebildet sein. In diesem Fall ist zwischen der Drainzone und der Rückseitenmetallisierung eine Anodenzone vom entgegengesetzten Leitungstyp wie die Drainzone vorgesehen.

Im Fall von als U-MOS bzw. V-MOS ausgebildeten Halbleiterbauelementen sind Gräben (engl.: Trench) in den Halbleiterkörper eingebracht, in denen die Steuerelektroden angeordnet sind. Diese Gräben können rechteckförmig, U-förmig, V-förmig, trapezförmig, etc. ausgebildet sein. Im Fall von grabenförmig ausgebildeten Halbleiterbauelementen reichen die Gräben von der Scheibenvorderseite über die Sourcezone, Basiszone, Zwischenzone, weitere Basiszone bis in die Innenzone des Halbleiterbauelementes hinein. Strukturbedingt bilden sich hier unter Steuerung der Steuerelektrode zwei verschiedene Kanäle aus, d.h. ein erster Kanal in der Basiszone und ein zweiter Kanal in der weiteren Basiszone. Der besondere Vorteil von solchen grabenförmigen Halbleiterbauelementen liegt darin, dass die Kanallängen deutlich geringer ausgebildet sein können als bei lateralen Halbleiterbauelementen. Halbleiterbauelemente mit Grabenstruktur können somit mit einem deutlich geringeren Zellabstand (engl.: pitch) zwischen zwei benachbarten Zellen ausgebildet sein. Damit bietet dieses besonders vorteilhafte Ausführungsbeispiel neben der verbesserten Latch-Up-Festigkeit noch den Vorteil eines kleineren pitches, was den Einschaltwiderstand R_{ON} zusätzlich verbessert.

Weitere Ausgestaltungen und Weiterbildungen der Erfindung sind den Unteransprüchen und der Beschreibung unter Bezugnahme auf die Figuren der Zeichnung entnehmbar.

Die Erfindung wird nachfolgend anhand der in den Figuren der Zeichnung angegebenen Ausführungsbeispiele näher erläutert. Es zeigt dabei:
- Figur 1: ein erstes Ausführungsbeispiel eines erfindungsgemäßen Halbleiterbauelementes mit zwei voneinander getrennten Basiszonen;
- Figur 2: ein zweites Ausführungsbeispiel des erfindungsgemäßen Halbleiterbauelementes;
- Figur 3: ein drittes Ausführungsbeispiel eines erfindungsgemäßen Halbleiterbauelementes;
- Figur 4: ein viertes Ausführungsbeispiel eines erfindungsgemäßen Halbleiterbauelementes;
- Figur 5: einen Querschnitt des in Figur 4 gezeigten Halbleiterbauelementes.

In allen Figuren der Zeichnung sind gleiche bzw. funktionsgleiche Elemente mit gleichen Bezugszeichen versehen worden.

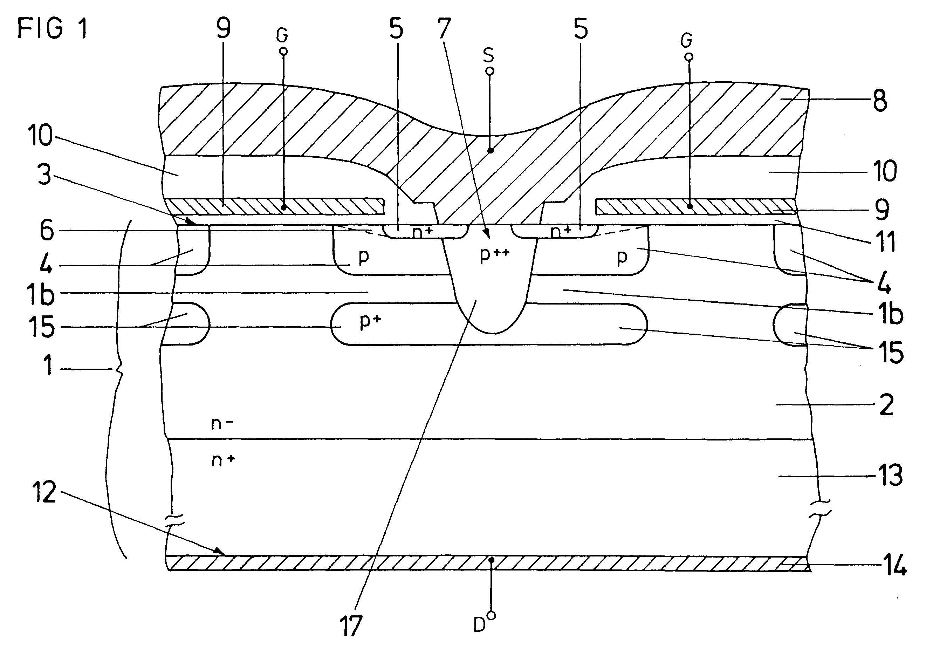

Figur 1 zeigt in einem Teilschnitt ein erstes Ausführungsbeispiel eines erfindungsgemäßen Halbleiterbauelementes. In Figur 1 ist mit 1 ein Halbleiterkörper - beispielsweise aus Silizium - bezeichnet. Der Halbleiterkörper 1 weist eine n⁻-dotierte Innenzone 2 auf. An einer ersten Oberfläche 3 ist eine p-dotierte Basiszone 4 in die Innenzone 2 eingebettet. In die Basiszone 4 sind wiederum zwei n⁺-dotierte Sourcezonen 5 derart eingebettet, dass die Basiszone 4 an verschiedenen Bereichen 6, 7 an die Oberfläche 3 des Halbleiterkörpers tritt und in den übrigen Bereichen von den Sourcezonen 5 bedeckt ist. Diese an die Oberfläche tretenden Bereiche 6, 7 sind zum einen die Kanalzonen 6 sowie der Kontaktbereich 7, der mit einer Sourceelektrode 8 verbunden ist. Ferner ist eine Gateelektrode 9 zu Steuerung der Kanalzone 6 vorgesehen, die über ein Oxid 10 gegen die Sourceelektrode 8 und die über ein Dielektrikum 11 gegen den Halbleiterkörper 1 im Bereich der Kanalzone 6 beabstandet bzw. isoliert ist. Die Gateelektrode 9 ist derart über dem Halbleiterkörper 1 angeordnet, dass zumindest der an die Oberfläche 3 der Basiszone 4 tretende Bereich der Kanalzone 6 von der Gateelektrode 9 bedeckt wird.

An der Rückseite des Halbleiterkörpers 1 ist zwischen einer zweiten Oberfläche 12 und der Innenzone 2 eine n⁺-dotierte Drainzone 13 vorgesehen. Die Drainzone 13 ist an der zweiten Oberfläche 12 großflächig über eine Drainelektrode 14 kontaktiert.

In Figur 1 ist somit ein als D-MOSFET ausgebildetes, vertikales Halbleiterbauelement dargestellt, bei dem die Sourceelektrode 8 mit einem Sourceanschluss S und die Gateelektrode 9 mit einem Gateanschluss G an der Wafervorderseite 3 des Halbleiterkörpers 1 angeordnet sind und an der Waferrückseite 12 die Drainelektrode 14 mit dem Drainanschluss D verbunden ist.

Die Gateelektrode 9 ist typischerweise aus hochdotiertem Polysilizium realisiert, ließe sich jedoch auch durch eine gängige Metallisierung oder ein Silizid ausgestalten. Die Sourceelektrode 8 und Drainelektrode 14 ist als gängige Metallisierung, beispielsweise Aluminium, Kupfer, Gold, etc. ausgebildet. Das Dielektrikum 11 zwischen Gateelektrode 9 und Halbleiterkörper 1 sowie das Oxid 10 sind typischerweise durch Siliziumdioxid (SiO₂) realisiert worden, können selbstverständlich auch durch andere Materialien, beispielsweise Siliziumnitrid (Si₃N₄), ausgebildet sein.

Erfindungsgemäß ist eine weitere p⁺-dotierte Basiszone 15 vorgesehen. Im Ausführungsbeispiel gemäß Figur 1 ist die weitere Basiszone als in der Innenzone 2 vergrabene Schicht dargestellt, die unterhalb der eigentlichen Basiszone 4 angeordnet ist und die eine höhere Dotierungskonzentration als die eigentliche Basiszone 4 aufweisen kann. Wesentlich ist hier, dass die weitere Basiszone 15 von der eigentlichen Basiszone 4 durch eine Zwischenzone 16, die in Figur 1 Bestandteil der Innenzone 2 ist, räumlich getrennt ist.

Ferner ist eine hochleitfähige, im vorliegenden Ausführungsbeispiel p⁺⁺-dotierte Sourcekontaktzone 17 vorgesehen, die eine niederohmige elektrische Verbindung der Basiszone 4 und der weiteren Basiszone 15 miteinander und mit der Sourceelektrode 8 gewährleistet. Die Basiszone 4 ist mit der Sourcezone 5 über einen Nebenschluss mit der Sourceelektrode 8 verbunden.

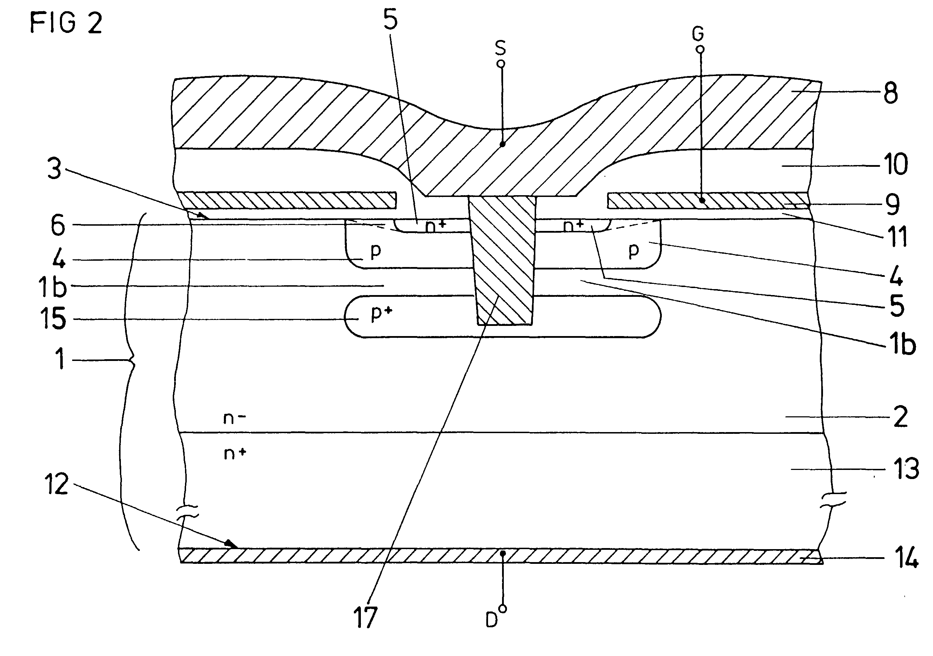

Figur 2 zeigt ein zweites Ausführungsbeispiel des erfindungsgemäßen Halbleiterbauelementes, bei dem die Sourcekontaktzone 17 als "Wolframstöpsel" ausgebildet ist. Dieser Wolframstöpsel besteht aus Wolfram oder einer Wolfram enthaltenden Legierung und bietet damit eine niederimpedante, hochleitfähige elektrische Verbindung zwischen Basiszone 4, weiterer Basiszone 15, Sourcezonen 5 und Sourceelektrode 8. In diesem Zusammenhang wäre es selbstverständlich auch denkbar, statt Wolfram ein anderes elektrisch leitfähiges Metall - beispielsweise Aluminium, Kupfer, Gold, Platin, etc. - zur Kontaktierung zu verwenden. Es ist hier lediglich darauf zu achten, dass am Metall-Halbleiter-Übergang zwischen dem jeweiligen metallischen "Kontaktstöpsel" 17 und den jeweiligen Basiszonen 4, 15 ein guter elektrischer, d. h. ohmscher Kontakt gewährleistet ist.

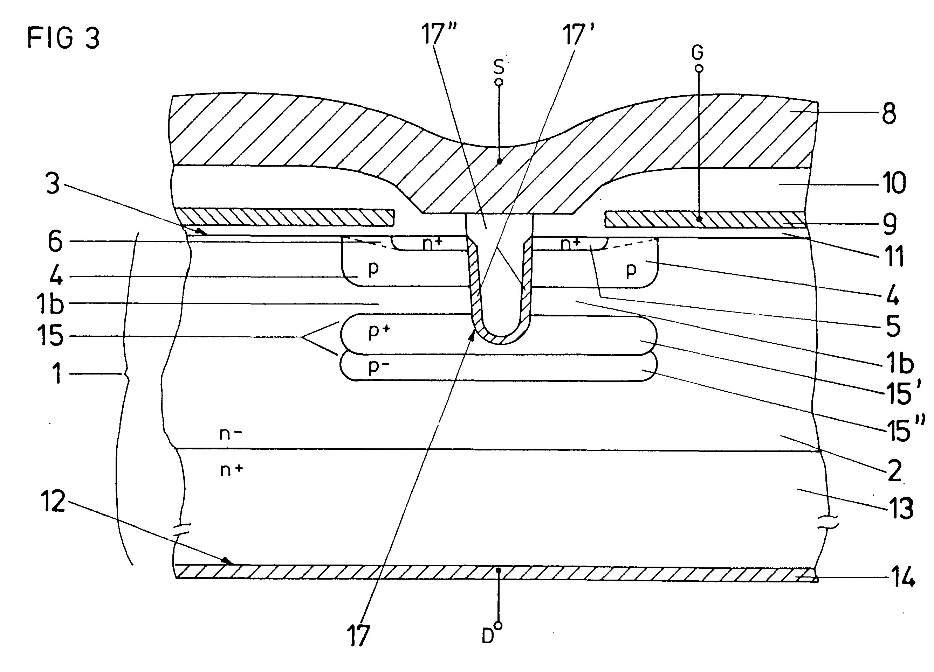

Figur 3 zeigt ein drittes Ausführungsbeispiel des erfindungsgemäßen Halbleiterbauelementes, bei dem die Sourcekontaktzone 17 grabenförmig in den Halbleiterkörper 1 eingebracht wurde und an den Grabenwänden ein Silizid 17' aufgebracht wurde. Die übrigen Bereiche 17'' der Sourcekontaktzone 17 sind durch ein hochdotiertes Polysilizium aufgefüllt. Das Silizid 17', das beispielsweise als Platinsilizid (PtSi) ausgebildet sein kann, gewährleistet wiederum eine niederimpedante Verbindung zwischen den voneinander beabstandeten Basiszonen 4, 15 und den Sourcezonen 5.

Darüber hinaus weist die weitere Basiszone 15 zwei Teilbereiche 15', 15'' auf, wobei der p⁺-dotierte erste Teilbereich 15' an den p⁻-dotierten zweiten Teilbereich 15'' angeschlossen ist. Die beiden Teilbereiche 15', 15" sind typischerweise durch zwei unterschiedliche Implantationen mit unterschiedlicher Dotierungsdosis und Eindringtiefe in den Halbleiterkörper 1 eingebracht worden.

Nachfolgend wird die Funktionsweise des erfindungsgemäßen als MOSFET ausgebildeten Halbleiterbauelements entsprechend den Figuren 1 bis 3 näher beschrieben.

Wird der MOSFET im Durchlassbetrieb betrieben, dann kann unter Steuerung der Gateelektrode 9 bei ausreichend hohem positiven Gatepotential an der Grenzschicht der p-dotierten Basiszone 4 eine n-dotierte Kanalzone 6 entstehen. Es bildet sich dann ein Strompfad vom Drainanschluss D über die Drainzone 13, die Innenzone 2, die Kanalzone 6 zur Sourcezone 5 und damit zum Sourceanschluss S. Im Sperrbetrieb weist die Gateelektrode 9 ein negatives oder ein Null-Potential auf, so dass sich keine Kanalzone 6 ausbilden kann. Bei Anlegen einer Drain-Source-Sperrspannung fließt der Sperrstrom nur noch durch die weitere Basiszone 15 und verursacht dort einen Spannungsabfall. Dieser Spannungsabfall kann vorteilhafterweise auch größer als die Flussspannung sein. Dieser Spannungsabfall in der weiteren Basiszone 15 führt aber nicht mehr zur Ladungsträgerinjektion und damit zum Einschalten des parasitären Bipolartransistors, da die Basis und der Kollektor des parasitären Bipolartransistors nunmehr vollständig von dessen Emitter (= Sourcezone) entkoppelt sind. Ein unerwünschtes Einschalten eines parasitären Bipolartransistors ist mit der Struktur entsprechend den Figuren 1 bis 3 grundsätzlich nicht mehr möglich.

Darüber hinaus kann sogar ein durch einen Sperrstrom in der weiteren Basiszone 15 verursachter Spannungsabfall deutlich größer sein als bei Strukturen entsprechend dem Stand der Technik, die ohne eine weitere Basiszone 15 ausgebildet sind.

Vorteilhaft ist auch, dass die vertikale Ausdehnung der weiteren Basiszone 15 aufgrund deren niedrigeren Dotierungskonzentration und somit höheren Schichtwiderstand deutlich geringer ausfallen kann, was zur Folge hat, dass die vertikale Ausdehnung des JFETs und damit auch der Widerstand dieses Teils des Halbleiterbauelementes geringer wird. Dies ist sogar vorteilhaft, da sich aufgrund des Spannungsabfalls in der weiteren Basiszone 15 der Ort eines Spannungsdurchbruchs vom äußeren Rand der weiteren Basiszone 15 hin zu dessen Mitte verlagert. Dadurch verringert sich auch das Risiko, das im Falle eines Lawinendurchbruchs Ladungsträger - im vorliegenden Fall sind das Löcher - in die eigentliche Basiszone 4 gelangen und das Einschalten des parasitären Bipolartransistors bewirken.

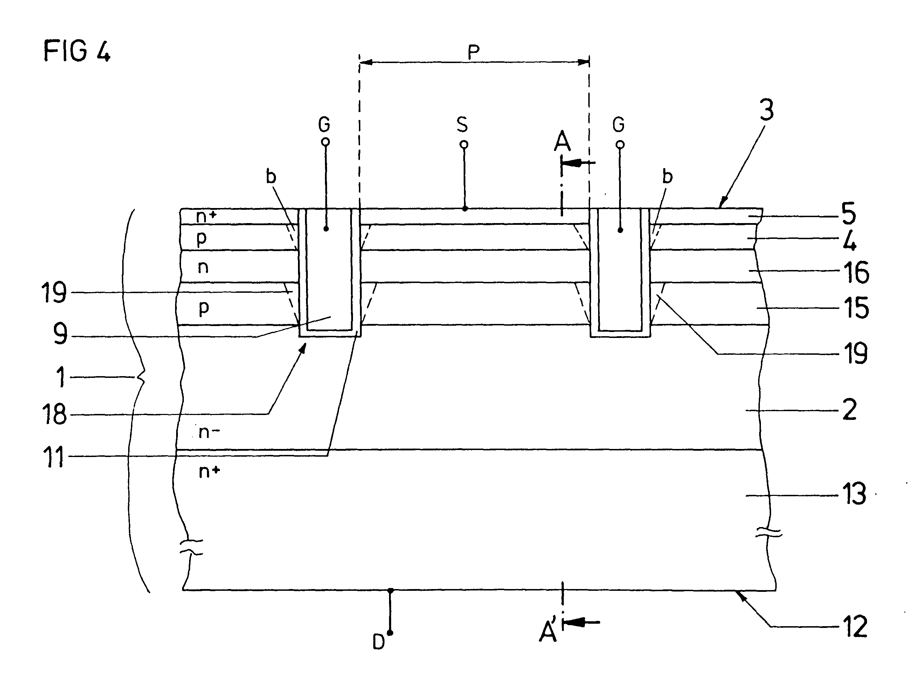

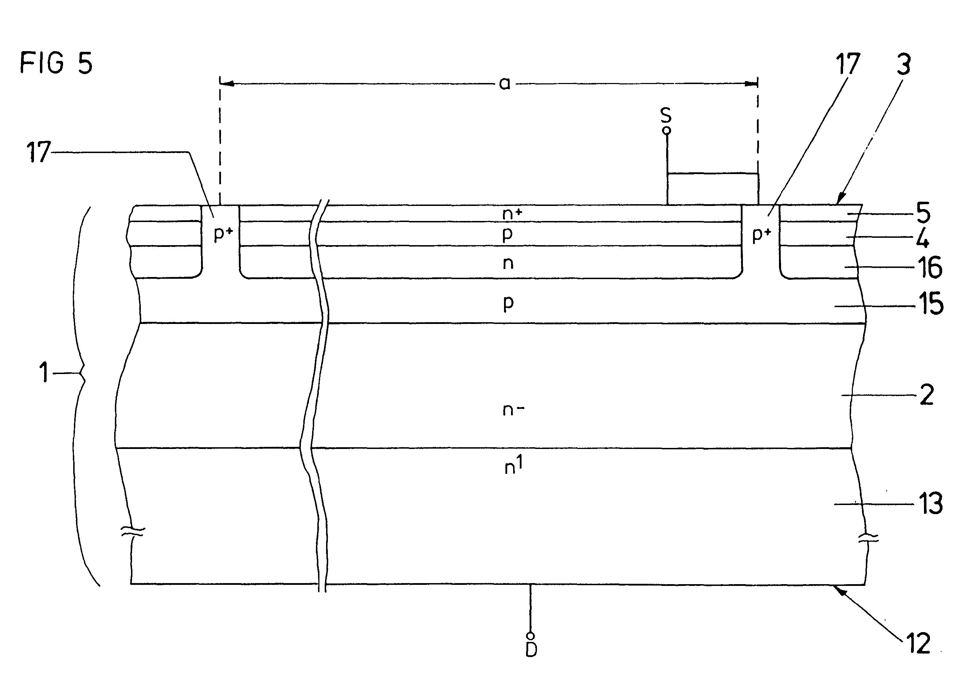

Figur 4 zeigt in einem Teilschnitt ein viertes Ausführungsbeispiel des erfindungsgemäßen Halbleiterbauelementes, Figur 5 einen Querschnitt entlang der Linie A, A' in Figur 4. In den Figuren 4 und 5 sind der besseren Übersicht halber sämtliche Metallisierungen und Elektroden, mit Ausnahme der Gateelektroden, nicht dargestellt worden.

In Figur 4 sind Gräben 18, in denen die Gateelektroden 9 und das Gateoxid 11 angeordnet sind, in den Halbleiterkörper 1 eingebracht. Die Gräben 18 reichen hier von der Wafervorderseite 3 über die Sourcezonen 5 und Basiszone 4, die Zwischenzone 16, die weitere Basiszone 15 bis in die Innenzone 2 hinein. Es sind hier jeweils zwei Kanalzonen 6, 18, die jeweils in den Basiszonen 4, 15 in unmittelbarer Nähe zu den Gateelektroden 9 angeordnet sind, vorgesehen. Die Kanalzone 6 ist hier notwendig, damit die Zwischenzone 16 zwischen den beiden Basiszonen 4, 15 floaten kann, d. h. ein undefiniertes Potential aufweist. Ein Sperrstrom über den pn-Übergang der Innenzone 2 und der weiteren Basiszone 15 kann damit ausschließlich über die weitere Basiszone 15 abfließen. Die Kanallänge der Kanalzone 6 kann hier vorteilhafterweise sehr kurz gewählt sein, da die maximal an der Basiszone 4 anliegende Sperrspannung dem Spannungsabfall in der weiteren Basiszone 15 entspricht, der durch den entsprechenden Sperrstrom verursacht wird.

Die Figur 4 und 5 zeigen ein als U-MOSFET ausgebildetes Halbleiterbauelement, jedoch wäre dieses Halbleiterbauelement beispielsweise durch V-förmige Gräben, auch als V-MOSFET ausbildbar.

Die Basiszonen 4, 15 können in einem sehr großen Abstand a - beispielsweise zwischen 20 bis 100 µm - zwischen zwei benachbarten Sourcekontaktzonen 17 angeordnet sein. Das erfindungsgemäße Halbleiterbauelement bietet neben der verbesserten Latch-up-Festigkeit noch den Vorteil eines sehr kleinen Zellenabstandes p, was insbesondere vorteilhaft auf den Einschaltwiderstand Rₒₙ ist.

In den Figuren der Zeichnung wurden als MOSFET ausgebildete Halbleiterbauelemente dargestellt. Jedoch ist die Erfindung auch auf andere vertikale Halbleiterbauelemente, beispielsweise IGBTs und Thyristoren, bei denen durch geeignete Maßnahmen das Einschalten eines parasitären Bipolartransistors unterdrückt werden soll, gleichermaßen geeignet. Im Falle eines als IGBT ausgebildeten Halbleiterbauelementes wäre bei den Strukturen entsprechend den Figuren 1 bis 4 lediglich eine (in den Figuren nicht dargestellte) Anodenzone zwischen Drainzone 13 und Waferrückseite 12 anzuordnen.

Für alle Ausführungsbeispiele der Figuren 1 bis 5 lassen sich selbstverständlich durch Austauschen aller Leitfähigkeitstypen n gegen p neue mögliche Ausführungsbeispiele bereitstellen. Darüber hinaus ist die Erfindung nicht ausschließlich auf selbstsperrende Halbleiterbauelemente beschränkt, sondern kann im Rahmen der Erfindung selbstverständlich auch auf selbstleitende Halbleiterbauelemente erweitert werden.

Zusammenfassend kann festgestellt werden, dass durch das wie beschrieben aufgebaute und betriebene erfindungsgemäße Halbleiterbauelement mit geringfügigen Mehraufwand ein optimaler Latch-up-Schutz mit einfachen Mitteln gewährleistet ist, ohne dass gleichzeitig die Nachteile von Halbleiterbauelementen nach dem Stand der Technik in Kauf genommen werden müssen. Das erfindungsgemäße Halbleiterbauelement ist darüber hinaus unabhängiger in der Wahl der Dotierungskonzentrationen in der Basiszone und ermöglicht somit größere Freiheitsgrade bei der Herstellungstechnologie.

Die vorliegende Erfindung wurde anhand der vorstehenden Beschreibung so dargelegt, um das Prinzip der Erfindung und dessen praktische Anwendung am besten zu erklären. Selbstverständlich lässt sich die vorliegende Erfindung im Rahmen des fachmännischen Handelns und Wissens in geeigneter Weise in mannigfaltigen Ausführungsformen und Abwandlungen realisieren.

### Bezugszeichenliste

- 1: Halbleiterkörper
- 2: Innenzone
- 3: erste Oberfläche, Wafervorderseite
- 4: (eigentliche) Basiszone
- 5: Sourcezone
- 6: Kanalzone
- 7: Kontaktbereich
- 8: Sourceelektrode
- 9: Steuerelektrode, Gateelektrode
- 10: Feldoxid
- 11: Gateoxid, Dielektrikum
- 12: zweite Oberfläche
- 13: Drainzone
- 14: Drainelektrode
- 15: (vergrabene) weitere Basiszone
- 15',: Teilbereich der weitere Basiszone
- 15'': Teilbereich der weitere Basiszone
- 16: Zwischenzone
- 17: Sourcekontaktzone
- 17': Silizid
- 17'': Polysiliziumauffüllung
- 18: Gräben, Trenches
- 19: weitere Kanalzone

- a: Abstand benachbarter Steuerelektroden
- p: Abstand benachbarter Sourcekontaktzonen, Pitch

- D: Drainanschluss
- G: Gateanschluss
- S: Sourceanschluss

## Patentansprüche

1. Feldeffektgesteuertes, vertikales Halbleiterbauelement, das in einem Halbleiterkörper (1) angeordnet ist, mit
mindestens einer Innenzone (2) des ersten Leitungstyps,
mindestens einer an die Innenzone (2) und an eine erste Oberfläche (3) des Halbleiterkörpers (1) angrenzende Basiszone (4) des zweiten Leitungstyps,
mindestens einer in jeder Basiszone (4) angeordneten Sourcezone (5) des ersten Leitungstyps,
**gekennzeichnet durch**
mindestens eine weitere Basiszone (15) des zweiten Leitungstyps, die von der Basiszone (4) **durch** eine Zwischenzone (16) des ersten Leitungstyps beabstandet ist, und
mindestens eine Sourcekontaktzone (17), die die Sourcezonen (5), die Basiszonen (4) und die weiteren Basiszonen (15) niederohmig miteinander verbindet.

2. Halbleiterbauelement nach Anspruch 1,
**dadurch gekennzeichnet,**
**dass** die weiteren Basiszonen (15) bezogen auf die erste Oberfläche (3) unterhalb der Basiszonen (4) angeordnet sind und als vergrabene Schichten in der Innenzone (2) ausgebildet sind und die Zwischenzone (16) Bestandteil der Innenzone (2) ist.

3. Halbleiterbauelement nach einem der vorstehenden Ansprüche,
**dadurch gekennzeichnet,**
**dass** mindestens eine weitere Basiszone (15) zwei Teilbereiche (15', 15'') enthält, die jeweils aneinander angeschlossen sind und die jeweils unterschiedliche Eindringtiefen in den Halbleiterkörper (1) und unterschiedliche Dotierungskonzentrationen aufweisen.

4. Halbleiterbauelement nach Anspruch 3,
**dadurch gekennzeichnet,**
**dass** der erste Teilbereich (15') eine höhere Dotierungskonzentration als der zweite Teilbereich (15'') aufweist, wobei der zweite Teilbereich (15'') bezogen auf die ersten Oberfläche (3) unterhalb des ersten Teilbereichs (15') angeordnet ist.

5. Halbleiterbauelement nach einem der vorstehenden Ansprüche,
**dadurch gekennzeichnet,**
**dass** die vertikale Ausdehnung der weiteren Basiszone (15) geringer ist als die vertikale Ausdehnung der Basiszone (4).

6. Halbleiterbauelement nach einem der vorstehenden Ansprüche,
**dadurch gekennzeichnet,**
**dass** die Sourcekontaktzone (17) ein hochdotiertes Material des zweiten Leitungstyps enthält und dass die Sourcekontaktzone (17) eine höhere Dotierungskonzentration als die Basiszone (4) und/oder die weitere Basiszone (15) aufweist.

7. Halbleiterbauelement nach einem der Ansprüche 1 bis 5,
**dadurch gekennzeichnet,**
**dass** die Sourcekontaktzone (17) Wolfram oder eine Wolfram enthaltende Legierung enthält.

8. Halbleiterbauelement nach einem der Ansprüche 1 bis 5,
**dadurch gekennzeichnet,**
**dass** die Sourcekontaktzone (17) ein Silizid (17'), das durch hochdotiertes Polysilizium (17'') aufgefüllt ist, enthält.

9. Halbleiterbauelement nach einem der vorstehenden Ansprüche,
**gekennzeichnet durch**
mindestens eine Steuerelektrode (9), die an der ersten Oberfläche (3) an die Basiszone (4) angrenzt und/oder von der Basiszone (4) über ein Dielektrikum (11) beabstandet ist, wobei unter Ansteuerung der Steuerelektroden (9) die Basiszone im eingeschalteten Zustand des Halbleiterbauelementes mindestens eine Kanalzone (6) generiert,
mindestens eine Sourceelektrode (8), die an der ersten Oberfläche (3) die Sourcekontaktzone (17) kontaktiert, und
mindestens eine Drainelektrode (14), die an einer zweiten Oberfläche (12) den Halbleiterkörper (1) oder eine in die Innenzone (2) eingebrachte Drainzone (13) des ersten Leitungstyps großflächig kontaktiert.

10. Halbleiterbauelement nach Anspruch 9,
**dadurch gekennzeichnet,**
**dass** zwischen der Drainzone (13) und der zweiten Oberfläche (12) ein Anodengebiet des zweiten Leitungstyps angeordnet ist.

11. Halbleiterbauelement nach einem der vorstehenden Ansprüche,
**dadurch gekennzeichnet,**
**dass** mindestens ein Graben (18) in den Halbleiterkörper (1) eingebracht ist und in jeweils einem Graben (18) eine Steuerelektrode (9) und gegebenenfalls ein Dielektrikum (11) angeordnet ist.

12. Halbleiterbauelement nach Anspruch 11,
**dadurch gekennzeichnet,**
**dass** die Gräben (18) von der ersten Oberfläche (3) durch die nacheinander angeordneten Sourcezonen (5), Basiszonen (4), Zwischenzonen (16), weitere Basiszonen (15) bis in die Innenzone (2) hineinreichen, wobei in den weiteren Basiszonen (15) unter Steuerung der Steuerelektrode (17) mindestens eine weitere Kanalzonen (19) generierbar ist.
